Europäisches Patentamt

European Patent Office

Office européen des brevets

(11) Numéro de publication : **0 461 051 A1**

## (12) DEMANDE DE BREVET EUROPEEN

(21) Numéro de dépôt : **91420171.0**

(51) Int. Cl.$^5$ : **G01R 33/06**

(22) Date de dépôt : **29.05.91**

(30) Priorité : 30.05.90 FR 9006966

(43) Date de publication de la demande :
**11.12.91 Bulletin 91/50**

(84) Etats contractants désignés :
**DE ES FR GB IT SE**

(71) Demandeur : **Société à Responsabilité Limitée
L'ELECTRICFIL INDUSTRIE
12, rue du Commandant Faurax
F-69452 Lyon Cedex 06 (FR)**

(72) Inventeur : **Bittebierre, Jean
Campagne des Grandes, Pont de l'Arc
F-13090 Aix en Provence (FR)**
Inventeur : **Biton, Philippe
3, avenue Général de Gaulle
F-69300 Caluire (FR)**

(74) Mandataire : **Ropital-Bonvarlet, Claude et al
Cabinet BEAU DE LOMENIE, 51, avenue
Jean-Jaurès
F-69007 Lyon (FR)**

(54) **Composant et capteur à effet Hall à détection différentielle.**

(57) — Composant à effet **Hall** comportant, en tant que composant appartenant à une classe de composants présentant des cycles d'hystérésis de caractéristiques voisines, des moyens aptes à soumettre les groupes de sonde, en l'absence d'organes perturbateurs situés en relation des sondes, à un champ d'induction déterminée, de manière qu'apparaisse une différence d'induction dite à vide ($B_o$) entre les groupes, qui soit au moins supérieure à la valeur du seuil haut de commutation ($B_H$) ou soit au moins inférieure à la valeur du seuil bas de commutation ($B_B$) ou soit comprise entre les seuils de commutation ($B_H$ et $B_B$) pour obtenir, en sortie du comparateur de niveau à hystérésis, un signal à un état logique déterminé.
— Application aux capteurs à effet **Hall** à détection différentielle.

FIG.2

La présente invention concerne le domaine technique des capteurs à effet **Hall** et elle vise, plus particulièrement, les composants comportant au moins deux cellules ou sondes à effet **Hall** permettant de mettre en oeuvre des méthodes de mesure différentielle.

Il est connu, dans l'art antérieur, un composant comportant deux cellules ou sondes à effet **Hall** et constituées chacune, à cet effet, par un barreau réalisé, par exemple, en silicium, en arseniure de gallium ou en antimoniure d'indium et dans lequel est injecté un courant électrique. Les barreaux sont soumis à un champ d'induction magnétique créé, généralement, par un aimant, de sorte qu'il apparaît, aux bornes de chaque barreau, une tension électrique dite de - "Hall".

Ce type de capteur, formé de l'association d'un aimant avec un tel composant, permet de déceler une variation de l'induction magnétique apparaissant, en particulier, lorsqu'un élément, muni d'organes perturbateurs du champ, défile devant les sondes. Cet élément mobile peut être constitué, par exemple, par une roue dentée. Un tel capteur permet donc de contrôler des positions et des déplacements et trouve un grand nombre d'applications, en particulier dans le domaine automobile où ce capteur peut être utilisé, par exemple, dans le cadre des fonctions d'allumage ou de freinage-antiblocage.

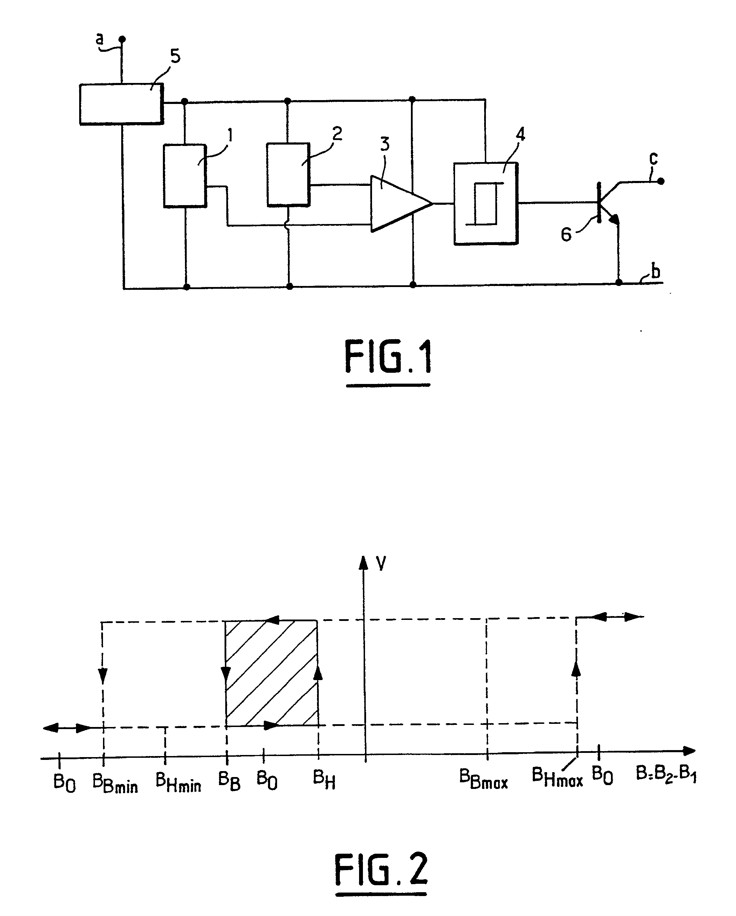

Le développement des technologies des circuits intégrés a permis de réaliser des composants sous la forme d'un circuit intégré comportant les deux sondes espacées de quelques millimètres, ainsi que des étages électroniques de traitement associés aux sondes. Tel que cela apparaît à la **fig. 1**, les sondes à effet **Hall** 1, 2 sont reliées à un amplificateur différentiel 3 dont la sortie attaque un comparateur 4 de niveau à hystérésis, tel qu'un trigger de **Schmitt** bien connu en soi. Les sondes 1, 2, l'amplificateur 3 et le comparateur 4 sont alimentés par une tension électrique qui se trouve régulée par un moyen adapté 5.

Le comparateur 4 délivre, par l'intermédiaire d'un étage de sortie 6, un signal $\underline{V}$ représentatif de la différence d'induction, détectée, respectivement, par les sondes 2 et 1, à savoir $B = B_2 - B_1$. Tel que cela ressort clairement de la **fig. 2**, le signal de sortie $\underline{V}$ est à un état logique déterminé, par exemple haut, lorsque la différence d'induction $\underline{B}$, entre les deux sondes 1, 2, est supérieure à la valeur d'un seuil haut de commutation $B_H$. Le comparateur 4 délivre un signal de sortie à un état logique complémentaire, bas dans l'exemple illustré, lorsque la différence d'induction $\underline{B}$ est inférieure à un seuil bas de commutation $B_B$. Le fonctionnement d'un tel capteur présente donc un cycle d'hystérésis permettant d'obtenir des transitions franches de la tension de sortie $\underline{V}$ pour des valeurs normales de l'induction ($B_H$ et $\overline{B}_B$), selon qu'elle varie, respectivement, en croissant ou en décroissant.

De tels composants présentent un inconvénient majeur qui est celui de leur dispersion de fabrication relativement élevée apparaissant sur la détermination du cycle d'hystérésis, à savoir les seuils de commutation $B_H$ et $B_B$. En effet, tel que cela ressort clairement de la **fig. 2**, la valeur du seuil haut de commutation $B_H$ peut être compris entre des valeurs $B_{Hmax}$ et $B_{Hmin}$ tandis que le seuil bas de commutation $B_B$ peut prendre une valeur comprise dans l'intervalle $B_{Bmax}$ et $B_{Bmin}$.

Les dispersions de fabrication de ces composants font que les sorties des différents capteurs fabriqués ne se trouvent pas dans un état logique déterminé et reproductible en présence et en l'absence des organes perturbateurs à détecter. De tels composants ne peuvent donc pas être utilisés directement pour une fabrication en série de capteurs comprenant un aimant assemblé, par exemple, par collage avec le composant, sans entraîner une augmentation du coût d'un tel capteur, engendrée par des opérations spécifiques pour assurer le montage de chaque capteur.

Par ailleurs, un autre inconvénient de ce type de capteurs provient du fait que leur fonctionnement dépend de la régularité de l'induction apparaissant à la surface de l'aimant associé à chaque capteur, ce qui, en pratique, est difficile à obtenir.

La présente invention vise donc à résoudre les inconvénients énoncés ci-dessus en proposant un composant à effet **Hall** à détection différentielle conçu pour compenser les dispersions de fabrication apparaissant sur les seuils de commutation déterminant le cycle d'hystérésis du fonctionnement du comparateur de niveau, associé à un tel composant.

L'invention vise, également, à offrir un capteur à effet **Hall** à détection différentielle, adapté pour présenter, en surface de l'aimant, une induction magnétique quasi, voire uniforme.

L'invention vise aussi à proposer un capteur à effet **Hall** à détection différentielle, conçu pour conserver les propriétés de détection des capteurs à large entrefer.

Pour atteindre les buts énoncés ci-dessus, le composant à effet **Hall** à détection différentielle comporte un premier et un second groupes de sondes à effet **Hall**, espacés l'un de l'autre, soumis à un champ d'induction créé, notamment, par au moins un aimant et placés en relation de distance d'un élément mobile muni d'organes perturbateurs du champ, de manière que les groupes associés en mode différentiel délivrent un signal, représentatif de la différence d'induction détectée qui est appliquée à un comparateur de niveau à hystérésis apte à délivrer, d'une part, un signal à un état logique déterminé pour une différence d'induction détectée supérieure à un seuil haut de commutation et, d'autre part, un signal à un état logique complémentaire pour une différence d'induction détectée inférieure à un seuil bas de commutation. Selon l'invention, le composant comporte, en tant que composant appartenant à une classe de composants présentant des cycles d'hystérésis de caractéristiques voisines, des moyens aptes à soumettre les groupes de sonde, en l'absence d'organes perturbateurs situés en relation des sondes, à un champ d'induction déterminée de manière qu'apparaisse une différence d'induction dite à vide entre les groupes, qui soit au moins supérieure à la valeur du seuil haut de commutation ou soit au moins inférieure à la valeur du seuil bas de commutation ou soit comprise entre les seuils de commutation pour obtenir, en sortie du comparateur de niveau à hystérésis, un signal à un état logique déterminé, quelles que soient les dispersions de la différence d'induction comprises entre la valeur minimale du seuil bas et la valeur maximale du seuil haut.

Selon une caractéristique avantageuse, les moyens d'application aux groupes, d'une différence d'induction à vide, sont formés par un ensemble polaire délimitant et/ou formant, d'une part, une première zone placée en relation du premier groupe et présentant une perméabilité magnétique déterminée et, d'autre part, une seconde zone contiguë à la première et placée en relation du second groupe et présentant une perméabilité magnétique donnée différente de celle de la première zone, de manière à obtenir la différence d'induction à vide entre les deux groupes de sonde.

Diverses autres caractéristiques ressortent de la description faite ci-dessous en référence aux dessins annexés qui montrent, à titre d'exemples non limitatifs, des formes de réalisation de l'objet de l'invention.

La **fig. 1** est un schéma bloc fonctionnel connu d'un capteur à effet **Hall** à détection différentielle.

La **fig. 2** est une courbe montrant le signal de sortie d'un capteur à effet **Hall** en fonction de la différence d'induction détectée.

La **fig. 3** est une vue schématique d'un exemple de réalisation du capteur à effet **Hall** selon l'invention.

La **fig. 4** est une vue de dessus du capteur illustré à la **fig. 3**.

La **fig. 5** est une vue en élévation d'une autre variante de réalisation du capteur selon l'invention.

Les **fig. 6, 6A, 6B** sont des vues en élévation d'une autre variante de réalisation du capteur selon l'invention, explicitant le fonctionnement de l'invention.

La **fig. 7** est une vue de dessus du capteur illustré à la **fig. 6**.

La **fig. 8** est une vue en élévation illustrant un autre exemple de réalisation de l'objet de l'invention.

La **fig. 9** est une vue en élévation montrant une autre variante de réalisation de l'invention.

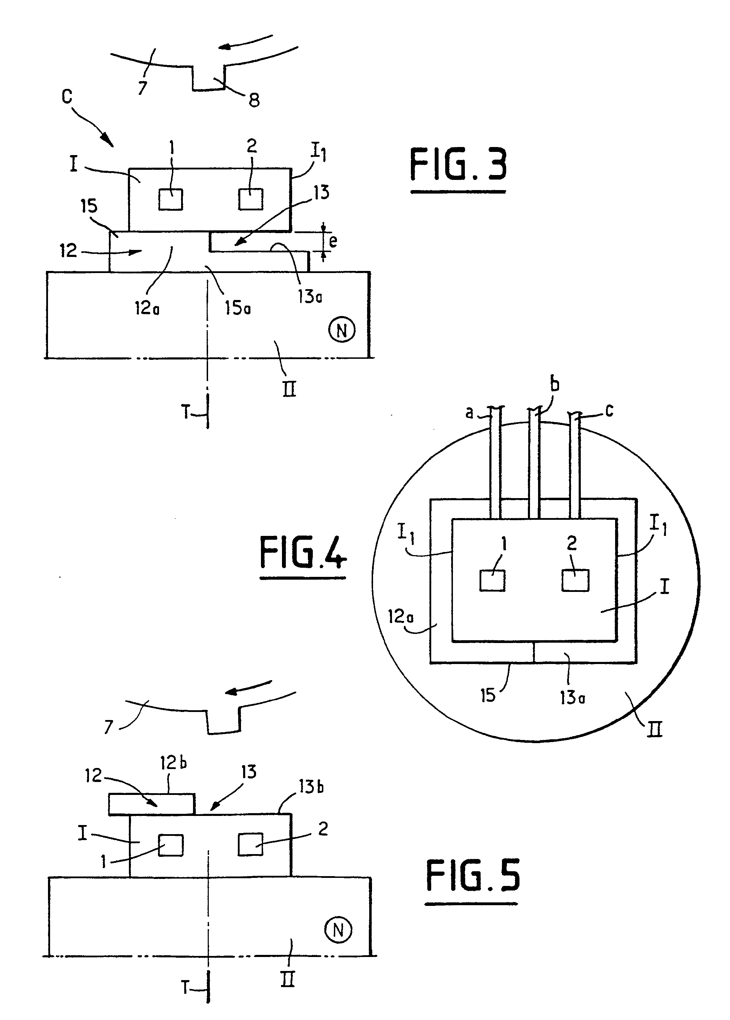

Dans l'exemple de réalisation illustré aux **fig. 3** et **4**, un capteur **C** à effet **Hall** est constitué, d'une part, par un composant **I**, tel qu'un circuit intégré présentant une forme, par exemple, parallélépipédique et, d'autre part, par un aimant **II**. Le composant **I**

comporte un premier **1** et un second **2** groupes de cellules ou de sondes à effet **Hall**, séparés l'un de l'autre d'une distance de quelques millimètres. Chaque groupe **1**, **2** comporte, en fonction de l'application visée, un nombre déterminé de sondes à effet **Hall** (au moins égal à deux) permettant de compenser les dérives en température. Chaque sonde est réalisée dans le circuit intégré, de préférence, en silicium ou en arséniure de gallium. Les sondes sont soumises à un champ d'induction magnétique créé, par exemple, à l'aide d'au moins un aimant **II**, par exemple cylindrique de section circulaire et constitué, dans l'exemple illustré, par un pôle nord **N** présentant un axe de symétrie **T**.

Le circuit intégré comporte, également, les étages électroniques de traitement **3** à **6**, comme illustré à la **fig. 1** et dont les fonctions ont été décrites ci-dessus. Le circuit intégré est équipé de deux connexions **a**, **b** d'alimentation électrique, ainsi que d'une connexion **c** de sortie de la tension **V** délivrée par le composant **I** et dont la loi de variation est montrée à la **fig. 2**. Cette tension **V** est donc représentative de la variation de la différence d'induction $B = B_2 - B_1$ détectée, respectivement, par les groupes **2** et **1** et apparaissant lorsqu'un élément **7**, muni d'organes **8** perturbateurs de champ, défile devant le capteur **C**.

Selon l'invention, le capteur **C** comporte des moyens aptes à soumettre ou à appliquer aux groupes **1**, **2** de sonde, en l'absence des organes perturbateurs **8** situés en relation des sondes, un champ d'induction de manière qu'une différence d'induction dite à vide $B_o$ apparaisse entre les groupes de sonde **1**, **2**. Cette différence d'induction à vide est choisie, pour une classe ou une famille de composants présentant des cycles d'hystérésis de caractéristiques voisines au niveau de leur positionnement, de manière à être soit au moins supérieure à la valeur du Seuil haut de commutation $B_H$, soit au moins inférieure au seuil bas de commutation $B_B$ ou soit comprise entre les seuils haut $B_H$ et bas $B_B$ du cycle d'hystérésis des composants de la classe. L'application de cette différence d'induction à vide $B_o$ aux groupes de sonde **1** et **2** permet de placer la sortie du comparateur **4** dans un état logique déterminé, en s'affranchissant des dispersions de fabrication intervenant sur la détermination des seuils de commutation $B_B$ et $B_H$ qui peuvent être compris, respectivement, entre $B_{Bmax}$ et $B_{Bmin}$ et entre $B_{Hmax}$ et $B_{min}$.

Il est à noter que, dans le cas où la valeur d'induction $B_o$ est choisie pour être comprise entre les valeurs $B_B$ et $B_H$, il est possible d'obtenir, selon le sens de rotation de l'élément porteur des organes perturbateurs de champ, des signaux de niveaux complémentaires permettant de détecter le sens de rotation de cet élément.

Selon un premier mode de réalisation, les moyens de création d'une différence d'induction à vide sont constitués par un ensemble polaire délimitant une première zone **12** placée en relation du premier groupe **1** de sonde et présentant une perméabilité magnétique déterminée. L'ensemble polaire délimite, également, une seconde zone **13** contiguë à la première zone **12**, placée en relation du second groupe **2** de sonde et présentant une perméabilité magnétique donnée différente de celle de la première zone, de maniére à obtenir la différence d'induction à vide $B_o$ entre les deux groupes de sonde **1** et **2**.

Selon l'exemple de réalisation illustré aux **fig. 3** et **4**, l'ensemble polaire est constitué par une pièce polaire **15**, réalisée, de préférence, en un matériau ferro ou ferrimagnétique, interposée entre le circuit intégré I et l'aimant II et assemblée par tous moyens convenables au circuit intégré et à l'aimant, par exemple par collage ou par assemblage mécanique. La pièce polaire **15**, qui posséde une perméabilité uniforme, présente un profil dissymétrique. Ainsi, la pièce polaire **15** comporte une base **15a** présentant, de préférence, en plan des dimensions sensiblement supérieures à la base du circuit intégré, de manière à déborder sur chacun des côtés verticaux $I_1$ du circuit, tel que cela apparaît clairement à la **fig. 4**. La pièce polaire **15** comporte aussi une partie saillante **12a** s'élevant à partir de la base **15a** et correspondant, par exemple, à la première zone **12** placée en relation ou à l'aplomb du premier groupe de sonde **1**. La pièce polaire **15** est aménagée pour présenter un dégagement **13a** formant la seconde zone **13** et placé en relation ou à l'aplomb du second groupe **2** de sonde. Le dégagement **13a** forme donc une discontinuité magnétique dans la pièce polaire **15**, d'une épaisseur **e** déterminée, de manière à favoriser le passage du champ d'induction à travers, dans l'exemple illustré, le groupe de sonde **1**, pour obtenir la différence d'induction à vide $B_o$ souhaitée.

Il apparaît donc possible, à partir de lots de composants triés par famille ou par classe, d'ajuster cette discontinuité et, notamment, l'épaisseur de ce dégagement, de manière que la valeur d'induction, séparant l'induction à vide $B_o$ et le cycle d'hystérésis du composant considéré, soit sensiblement identique d'un composant à l'autre.

La **fig. 5** illustre une autre variante de réalisation de l'objet de l'invention dans laquelle l'ensemble polaire est placé entre le composant I et l'élément mobile **7**. Selon cette variante, l'ensemble polaire est constitué par une pièce **12b** rapportée sur le circuit intégré, en relation, par exemple, du groupe de sonde **1**, pour constituer la première zone **12**. La pièce **12b** délimite un espace libre adjacent **13b** pour former la seconde zone **13** de l'ensemble polaire.

Bien entendu, il pourrait être prévu de réaliser l'ensemble polaire décrit selon les variantes illustrées aux **fig. 3** à **5**, directement à l'intérieur du capteur. De plus, il peut être envisagé de placer, entre l'élément mobile **7** et le capteur I, l'ensemble polaire, tel que décrit aux **fig. 3** et **4**.

Toutefois, le positionnement de l'ensemble polaire, entre le capteur I et l'élément mobile **7**, ne doit pas empêcher une détection du passage des organes perturbateurs de champ, ce qui est susceptible d'apparaître si l'entrefer, correspondant à la mesure séparant le circuit des organes perturbateurs, devient trop élevé.

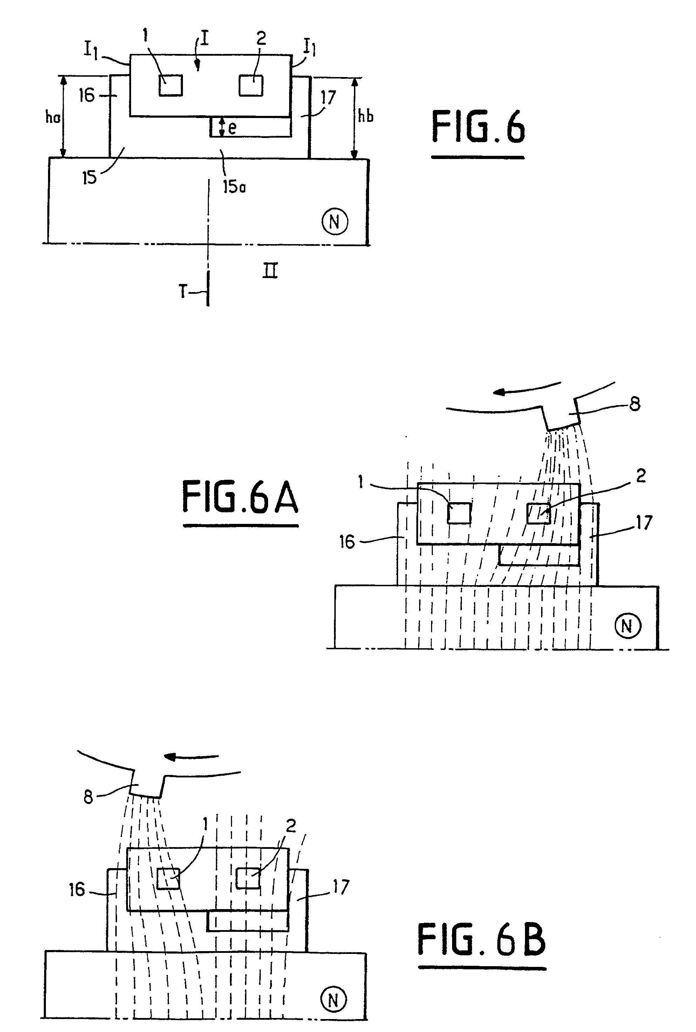

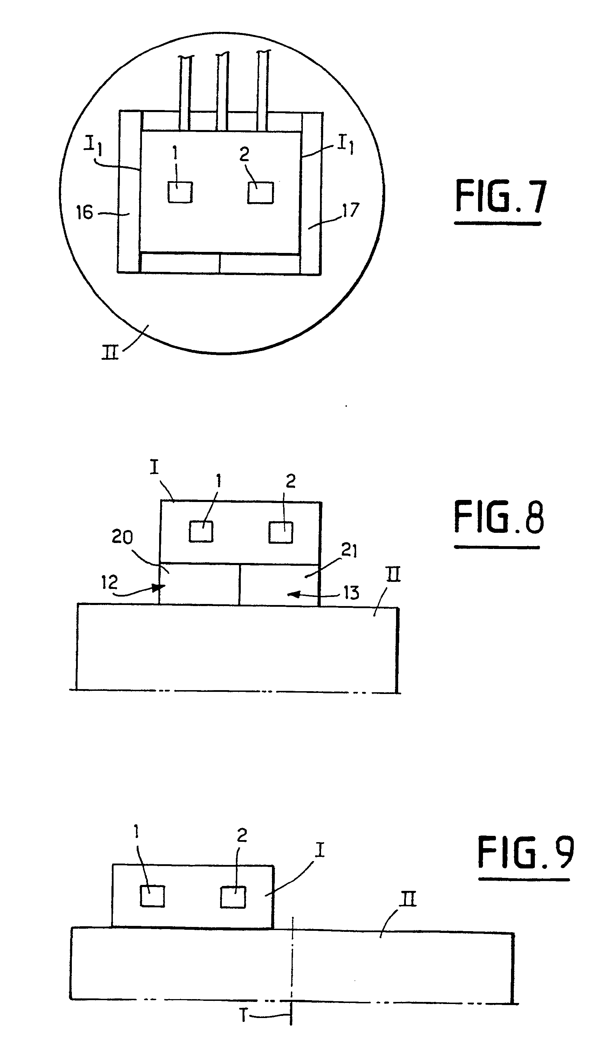

Les **fig. 6** et **7** illustrent une variante de réalisation de l'objet de l'invention permettant de conserver les propriétés de détection à large entrefer. Selon l'exemple illustré, la pièce polaire **15** décrite ci-dessus est pourvue de deux branches **16**, **17** s'élevant à par-tir de la base **15a** et enserrant deux côtés opposés $I_1$ du capteur, chacune sur une hauteur déterminée **ha**, **hb** prise entre la face supérieure de l'aimant II et l'extrémité libre des branches. Avantageusement, les branches **16**, **17** s'élèvent en relation des côtés opposés $I_1$ du capteur qui sont perpendiculaires à l'axe passant par les groupes de sonde **1** et **2**. Cette pièce polaire, qui présente donc une forme générale en "U" permet d'homogénéiser, en l'absence du dégagement **13a**, l'induction dans la partie centrale du circuit où sont placés les groupes sonde. Cette homogénéisation est rendue d'autant plus nécessaire que l'induction apparaissant en surface de l'aimant n'est pas régulière. La hauteur **ha**, **hb** des branches est déterminée de manière à assurer une homogénéisation maximale de l'induction, tout en ne réduisant pas la sensibilité du capteur par la diminution de l'entrefer. Avantageusement, il peut être prévu de mettre en oeuvre des branches de hauteurs différentes, de manière à-favoriser le passage de l'induction dans l'une des branches par rapport à l'autre. Cette disposition contribue aussi, de la même façon que le dégagement **13a**, à la création d'une différence d'induction. Une possibilité de réglage de l'induction à vide est donc offerte par le choix des hauteurs différentes pour les branches **16**, **17**.

Dans l'exemple illustré sur les fig. **6**, **6A** et **6B**, la pièce polaire **15** favorise la propagation du champ à travers le groupe de sonde **1**, de sorte que la différence d'induction $B = B_2 - B_1$ est négative. La pièce **15** est prévue pour atteindre la condition du champ d'induction à vide $B_o$, c'est-à-dire, dans le cas illustré, $B_o$ négatif, inférieure au cycle d'hystérésis. La sortie du capteur est donc à l'état bas (**fig. 2**). Si un organe perturbateur **8** se positionne en relation de proximité du groupe de sonde **2**, les lignes de champ d'induction sont concentrées dans la branche **17** et, en particulier, dans le groupe de sonde **2** qui se trouve positionné à proximité de la branche **17** (**fig. 6A**). Dans ces conditions, la différence de champ obtenue $B$ peut être supérieure à la valeur du seuil haut $B_H$. La sortie du capteur est à l'état logique haut. Lorsque l'organe perturbateur **8** du champ d'induction arrive en relation de proximité du groupe de sonde **1**, les lignes de champ se concentrent au niveau de la branche 16 et donc du groupe de sonde 1 (fig. 6B). La différence d'induction $\underline{B}$ obtenue peut donc être inférieure à la valeur du seuil de commutation bas $B_B$, de sorte que la sortie du capteur passe à l'état logique bas.

La **fig. 8** illustre une autre variante de réalisation dans laquelle l'ensemble polaire est formé de deux pièces distinctes 20, 21 contiguës, constituant chacune une zone **12, 13** à perméabilité donnée différente. Bien entendu, ces pièces peuvent être pourvues ou non des branches polaires 16, 17, telles que décrites ci-dessus.

Dans les différents exemples de réalisation, illustrés ci-dessus, il doit être considéré que l'axe de symétrie $\underline{T}$ de l'aimant passe par le milieu de l'intervalle séparant les deux groupes de sonde. Bien entendu, il pourrait être envisagé un second mode de réalisation prévoyant de décentrer l'aimant II par rapport au circuit I, de manière à obtenir, en combinaison avec l'ensemble polaire, la différence d'induction à vide $B_o$. Dans le même sens, il pourrait être prévu de décentrer uniquement le circuit I par rapport à l'aimant II ne créant pas une induction symétrique, de manière à obtenir l'induction à vide $B_o$ (**fig. 9**).

L'invention n'est pas limitée aux exemples décrits et représentés, car diverses modifications peuvent y être apportées sans sortir de son cadre.

## Revendications

1 - Composant à effet **Hall** à détection différentielle, du type comportant un premier (**1**) et un second (**2**) groupes de sondes à effet **Hall**, espacés l'un de l'autre, soumis à un champ d'induction créé, notamment, par au moins un aimant (**II**) et placés en relation de distance d'un élément mobile (**7**) muni d'organes perturbateurs (**8**) du champ, de manière que les groupes associés en mode différentiel délivrent un signal (**V**), représentatif de la différence d'induction (**B**) détectée qui est appliquée à un comparateur de niveau à hystérésis (**4**) apte à délivrer, d'une part, un signal à un état logique déterminé pour une différence d'induction détectée supérieure à un seuil haut de commutation ($B_H$) et, d'autre part, un signal à un état logique complémentaire pour une différence d'induction détectée inférieure à un seuil bas de commutation ($B_B$),

caractérisé en ce qu'il comporte, en tant que composant appartenant à une classe de composants présentant des cycles d'hystérésis de caractéristiques voisines, des moyens aptes à soumettre les groupes de sonde, en l'absence d'organes perturbateurs (**8**) situés en relation des sondes, à un champ d'induction déterminée, de manière qu'apparaisse une différence d'induction dite à vide ($B_o$) entre les groupes (**1** et **2**), qui soit au moins supérieure à la valeur du seuil haut de commutation ($B_H$) ou soit au moins inférieure à la valeur du seuil bas de commutation ($B_B$) ou soit comprise entre les seuils de commutation ($B_H$ et $B_B$) pour obtenir, en sortie du comparateur (**4**) de niveau à hystérésis, un signal à un état logique déterminé, quelles que soient les dispersions de la différence d'induction comprises entre la valeur minimale du seuil bas ($B_{Bmin}$) et la valeur maximale du seuil haut ($B_{Hmax}$).

2 - Composant selon la revendication 1, caractérisé en ce que les moyens d'application aux groupes d'une différence d'induction à vide sont constitués par un ensemble polaire délimitant et/ou formant, d'une part, une première zone (**12**) placée en relation du premier groupe (**1**) et présentant une perméabilité magnétique déterminée et, d'autre part, une seconde zone (**13**), contiguë à la première et placée en relation du second groupe (**2**) et présentant une perméabilité magnétique donnée différente de celle de la première zone, de manière à obtenir la différence d'induction à vide ($B_o$) entre les deux groupes de sonde.

3 - Composant selon la revendication 2, caractérisé en ce que l'ensemble polaire est rapporté sur le composant.

4 - Composant selon la revendication 2, caractérisé en ce qu'un ensemble polaire fait partie intégrante du composant.

5 - Composant selon la revendication 3 ou 4, caractérisé en ce que l'ensemble polaire est positionné entre l'aimant (**II**) et les groupes de sondes (**1, 2**).

6 - Composant selon la revendication 3 ou 4, caractérisé en ce que l'ensemble polaire est rapporté entre l'élément mobile (**8**) et les groupes de sondes (**1, 2**).

7 - Composant selon ta revendication 3 ou 4, caractérisé en ce que l'ensemble polaire est formé de deux pièces (**20, 21**) contiguës, constituant chacune une zone (**12, 13**) à perméabilité prédéterminée différente.

8 - Composant selon la revendication 3 ou 4, caractérisé en ce que l'ensemble polaire est formé par une pièce (**15**) disymétrique comportant une base (**15a**) à partir de laquelle s'élève une partie saillante (**12a**) formant la première zone (**12**) et comporte un dégagement adjacent (**13a**) constituant la seconde zone (**13**).

9 - Composant selon la revendication 3 ou 4, caractérisé en ce que l'ensemble polaire est formé par une pièce polaire (**12b**) constituant la première zone (**12**) et délimitant un espace libre (**13a**) adjacent correspondant à la seconde zone (**13**).

10 - Composant selon la revendication 7 ou 8, caractérisé en ce que la pièce polaire est prolongée par des branches (**16, 17**) s'étendant, au moins partiellement, en relation de deux côtés opposés du circuit intégré pour assurer l'obtention d'un champ d'induction uniforme au niveau des deux groupes de sondes (**1, 2**), en l'absence du dégagement (**13a**) et lorsque l'aimant ne crée pas une induction symétrique.

**11** - Composant selon la revendication 10, caractérisé en ce que chaque branche (**16, 17**) possède une hauteur (**ha, hb**) prédéterminée différente l'une par rapport à l'autre.

**12** - Composant selon la revendication 1, caractérisé en ce que les moyens d'application d'une différence d'induction à vide sont réalisés par le décentrage des groupes de sonde (**1, 2**) par rapport à l'axe de symétrie de l'aimant, lorsque ce dernier ne crée pas une induction symétrique.

**13** - Composant selon les revendications 1 et 2, caractérisé en ce que les moyens d'application d'une différence d'induction à vide sont réalisés par le décentrage des groupes de sonde (**1, 2**) par rapport à l'axe de symétrie de l'aimant et par un ensemble polaire délimitant et/ou formant deux zones (**12, 13**) à perméabilités magnétiques différentes.

**14** - Composant selon la revendication 2, caractérisé en ce que l'ensemble polaire est réalisé en un matériau ferromagnétique ou ferrimagnétique.

**15** - Capteur à effet **Hall**, caractérisé en ce qu'il comporte un aimant (**II**) assemblé à un composant conforme à l'une des revendications 1 à 14.

# FIG.1

# FIG.2

FIG.3

FIG.4

FIG.5

8

EP 0 461 051 A1

FIG.6

FIG.6A

FIG.6B

9

**FIG.7**

**FIG.8**

**FIG.9**

Office européen
des brevets

# RAPPORT DE RECHERCHE EUROPEENNE

Numero de la demande

EP    91 42 0171

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4518918 (G.D.AVERY)<br>* colonne 1, ligne 59 - colonne 2, ligne 37; figure 3 *<br>--- | 1 | G01R33/06 |
| A | IBM TECHNICAL DISCLOSURE BULLETIN.<br>vol. 28, no. 10, mars 1986, NEW YORK US<br>pages 4498 - 4499;<br>"Magnetoresistive sensing of print actuators"<br>* le document en entier *<br>--- | 1 | |
| A | US-A-3800193 (K.G.ASHAR)<br>* colonne 2, lignes 44 - 63 *<br>--- | 1-4 | |
| A | EP-A-319737 (ALCATEL N.V.)<br>* colonne 1, ligne 31 - colonne 2, ligne 7 *<br>----- | 1 | |

DOMAINES TECHNIQUES
RECHERCHES (Int. Cl.5)

G01R

Le présent rapport a été établi pour toutes les revendications

| Lieu de la recherche | Date d'achèvement de la recherche | Examinateur |
|---|---|---|
| LA HAYE | 05 SEPTEMBRE 1991 | SWARTJES H.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P0402)